# EUROPÄISCHE PATENTSCHRIFT

(11) **EP 2 462 621 B1**
(45) Veröffentlichungstag und Bekanntmachung des Hinweises auf die Patenterteilung: **17.08.2016**
(21) Anmeldenummer: 10721177.3
(22) Anmeldetag: 09.06.2010
(51) Int. Cl.: H01L 29/872, H01L 21/329, H01L 29/06

(54) **HALBLEITERANORDNUNG MIT EINER SCHOTTKY-DIODE**
SEMICONDUCTOR ARRANGEMENT COMPRISING A SCHOTTKY DIODE
ENSEMBLE SEMICONDUCTEUR COMPORTANT UNE DIODE SCHOTTKY

(30) Priorität: 05.08.2009 DE 102009028252
(43) Veröffentlichungstag der Anmeldung: 13.06.2012
(73) Patentinhaber: Robert Bosch GmbH, 70442 Stuttgart (DE)
(72) Erfinder: QU, Ning, 72770 Reutlingen (DE); GOERLACH, Alfred, 72127 Kusterdingen (DE)
(86) Internationale Anmeldenummer: PCT/EP2010/058060
(87) Internationale Veröffentlichungsnummer: WO 2011/015393

(56) Entgegenhaltungen:
- EP-A1- 1 139 433
- WO-A2-2006/122252
- DE-A1- 19 820 734
- DE-A1-102004 053 761
- JP-A- 2001 085 704

## Beschreibung

### Stand der Technik

Die Erfindung betrifft Varianten von **T**rench-**J**unction-**B**arrier-**S**chottky-**D**ioden, die im Folgenden vereinfacht **TJBS** genannt werden. **TJBS**-Dioden bieten größere Freiräume für Bauelementeauslegung und eignen sich insbesondere als Z-Leistungsdiode mit einer Durchbruchspannung von ca. 20V für den Einsatz in Kfz-Generatorsystem.

In modernen Kraftfahrzeugen werden immer mehr Funktionen mit elektrischen Bauelementen realisiert. Dadurch entsteht ein immer höherer Bedarf an elektrischer Leistung. Um diesen Bedarf zu decken, muss die Effizienz des Generatorsystems im Kfz gesteigert werden.

Bis heute werden in der Regel PN-Dioden als Z-Dioden im Kfz-Generatorsystem eingesetzt. Vorteile der PN-Dioden sind einerseits der niedrige Sperrstrom und andererseits die hohe Robustheit. Der Hauptnachteil ist die hohe Flussspannung U F. Bei Raumtemperatur beginnt Strom erst mit UF=0.7V zu fließen. Unter normaler Betriebsbedingung, z. B. einer Stromdichte von 500A/cm², steigt UF bis über 1V an, was einen unvernachlässigbaren Verlust der Effizienz bedeutet.

Theoretisch stehen Schottky-Dioden als Alternative zur Verfügung. Schottky-Dioden haben eine deutlich niedrigere Flussspannung als PN-Dioden, beispielweise 0.5V bis 0.6V bei einer hohen Stromdichte von 500A/cm². Außerdem bieten Schottky-Dioden als Majoritätsträgerbauelemente Vorteile bei schnellem Schaltbetrieb. Der Einsatz von Schottky-Dioden in Kfz-Generatorsystemen erfolgt jedoch bis heute nicht. Dies ist auf einige entscheidende Nachteile von Schottky-Dioden zurückzuführen: 1) höherer Sperrstrom im Vergleich zu PN-Dioden, 2) starke Abhängigkeit des Sperrstroms von Sperrspannung, und 3) schlechte Robustheit, insbesondere bei Hochtemperatur.

Es gibt bereits Vorschläge, Schottky-Dioden zu verbessern. Eine **JBS** (**J**unction-**B**arrier-**S**chottky-Diode) ist aus: S. Kunori, etc., "Low leakage current Schottky barrier diode", Proceedings of 1992 International Symposium on Power Semiconductors & ICs, Tokyo, pp. 80-85 bekannt.

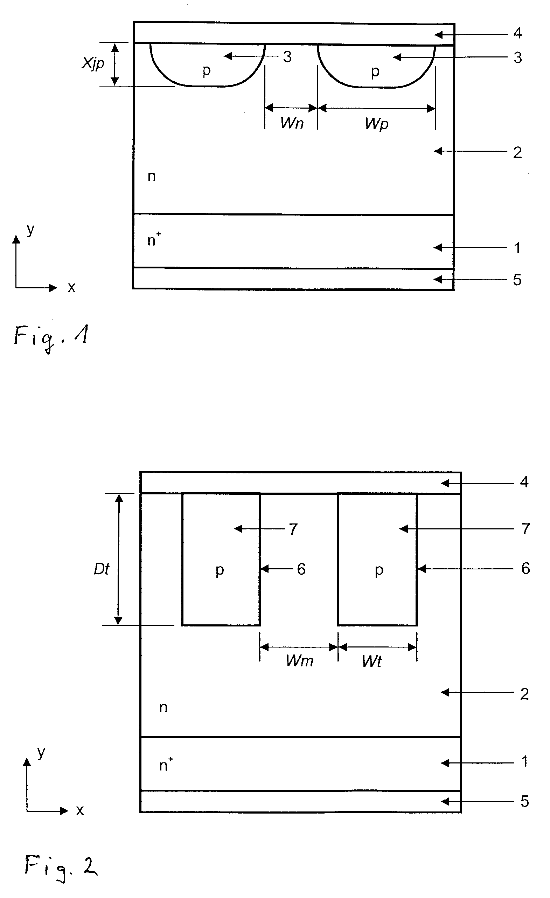

Wie Fig. 1 zeigt, besteht die JBS aus einem n⁺-Substrat 1, einer n-Epischicht 2, mindestens zwei in die n-Epischicht 2 diffundierten p-Wannen 3 und Metallschichten an der Vorderseite 4 und an der Rückseite 5 des Chips. Elektrisch gesehen ist die JBS eine Kombination von PN-Diode mit einem PN-Übergang zwischen den p-Wannen 3 als Anode und der n-Epischicht **2** als Kathode und einer Schottky-Diode mit einer Schottky-Barriere zwischen der Metallschicht **4** als Anode und der n-Epischicht **2** als Kathode. Die Metallschicht an der Rückseite des Chips **5** dient als Kathodenelektrode, die Metallschicht an der Vorderseite des Chips **4** als Anodenelektrode mit ohmschem Kontakt zu den p-Wannen **3** und gleichzeitig als Schottky-Kontakt zur n-Epischicht **2.**

Wegen der kleinen Flussspannung der Schottky-Diode im Vergleich zur PN-Diode fließen Ströme in der Flussrichtung nur durch den Bereich der Schottky-Diode. Folgedessen ist die effektive Fläche (pro Flächeneinheit) für den Stromfluss in Flussrichtung bei einer JBS deutlich kleiner als bei einer konventionellen Planar-Schottky-Diode.

In der Sperrrichtung dehnen sich die Raumladungszonen mit steigender Spannung aus und stoßen sich bei einer Spannung, die kleiner als die Durchbruchspannung der JBS ist, in der Mitte des Bereichs zwischen den benachbarten p-Wannen **3** zusammen. Dadurch wird der Schottky-Effekt, der für die hohen Sperrströme verantwortlich ist, teilweise abgeschirmt und der Sperrstrom reduziert. Dieser Abschirmeffekt ist stark von den Strukturparametern Eindringtiefe der p-Diffusion *Xjp,* Abstand zwischen den p-Wannen *Wn* sowie Breite der p-Wanne *Wp* und von Dotierkonzentrationen der p-Wanne **3** und der n-Epischicht **2** abhängig, siehe Fig. 1.

Stand der Technik zur Realisierung der p-Wannen einer JBS ist p-Implantation und anschließende p-Diffusion. Durch laterale Diffusion in der x-Richtung, deren Tiefe vergleichbar mit der vertikalen Diffusion in der y-Richtung ist, entstehen zylindrische p-Wannen in der zweidimensionalen Darstellung (unendliche Länge in der z-Richtung senkrecht zur x-y-Ebene), deren Radius der Eindringtiefe *Xjp* entspricht. Wegen der radialen Ausdehnung der Raumladungszonen zeigt diese Form von p-Wannen keine sehr wirkungsvolle Abschirmung des Schottky-Effektes. Es ist nicht möglich, allein durch tiefere p-Diffusion die Abschirmwirkung zu verstärken, da gleichzeitig auch die laterale Diffusion entsprechend breiter wird. Den Abstand zwischen den p-Wannen *Wn* zu verkleinern ist auch keine gute Lösung, da dadurch zwar die Abschirmwirkung verstärkt, die effektive Fläche für den Stromfluss in Flussrichtung wird aber weiter reduziert wird.

Eine Alternative zur Verbesserung der Abschirmwirkung des Schottky-Effekts bzw. Barrier Lowering Effect einer JBS wird in der DE-OS 10 2004 053 761 beschrieben und als TJBS bezeichnet. Fig. 2 zeigt eine solche **TJBS** (**T**rench-**J**unction-**B**arrier-**S**chottky-**D**iode) mit ausgefüllten Gräben. Die TJBS besteht aus einem n⁺-Substrat **1,** einer n-Epischicht 2, mindestens zwei in die n-Epischicht **2** eingeätzten Gräben bzw. Trenches **6** und Metallschichten an der Vorderseite des Chips **4** als Anodenelektrode und an der Rückseite des Chips **5** als Kathodenelektrode. Die Gräben werden mit p-dotiertem Si oder Poly-Si **7** ausgefüllt. Insbesondere kann die Metallschicht **4** auch aus mehreren unterschiedlichen, übereinander liegenden Metallschichten bestehen. Der Übersichtlichkeit ist dies in Abb. 2 nicht eingezeichnet. Elektrisch gesehen ist die TJBS eine Kombination von PN-Diode (PN-Übergang zwischen den p-dotierten Gräben 7 als Anode und der n-Epischicht **2** als Kathode) und Schottky-Diode (Schottky-Barriere zwischen der Metallschicht **4** als Anode und der n-Epischicht **2** als Kathode).

Wie bei einer konventionellen JBS fließen Ströme in der Flussrichtung nur durch die Schottky-Diode. Wegen fehlender lateraler p-Diffusion ist jedoch die effektive Fläche für Stromfluss in der Flussrichtung bei der TJBS deutlich größer als bei konventioneller JBS. In der Sperrrichtung dehnen sich die Raumladungszonen mit steigender Spannung aus und stoßen sich bei einer Spannung, die kleiner als die Durchbruchspannung der TJBS ist, in der Mitte des Bereichs zwischen den benachbarten Gräben **6** zusammen. Wie bei der JBS wird dadurch der für hohe Sperrströme verantwortliche Schottky-Effekt abgeschirmt und die Sperrströme reduziert. Dieser Abschirmeffekt ist stark von Strukturparametern Tiefe des Grabens *Dt,* Abstand zwischen den Gräben *Wm* sowie Breite des Grabens *Wt* und von Dotierkonzentrationen der p-Wanne **7** und der n-Epischicht **2** abhängig, siehe Fig. 2.

Zur Realisierung der Gräben bei der TJBS wird auf die p-Diffusion verzichtet. Dadurch gibt es keine negative Auswirkung von lateraler p-Diffusion wie bei konventioneller JBS. Eine quasi-eindimensionale Ausdehnung der Raumladungszonen in dem Mesa-Bereich zwischen den Gräben **6** kann ohne weiteres realisiert werden, da die Tiefe des Grabens *Dt,* ein wichtiger Strukturparameter für die Abschirmung des Schottky-Effektes, nicht mehr mit der effektiven Fläche für Stromfluss in der Flussrichtung korreliert. Die Abschirmwirkung von Schottky-Effekten ist damit deutlich effektiver als bei der JBS mit diffundierten p-Wannen.
Andererseits bietet die TJBS eine hohe Robustheit durch seine Klammerfunktion. Die Durchbruchspannung der PN-Diode *BV_pn* wird so ausgelegt, dass *BV_pn* niedriger als die Durchbruchspannung der Schottky-Diode *BV*_*schottky* ist und der Durchbruch am Boden der Gräben stattfindet. Im Durchbruchsbetrieb fließt der Sperrstrom dann nur durch den PN-Übergang. Flussrichtung und Sperrrichtung sind damit geometrisch getrennt. Die TJBS verfügt damit über eine ähnliche Robustheit wie eine PN-Diode. Außerdem tritt bei einer TJBS die Injektion von "heißen" Ladungsträgern in Oxide nicht auf, da keine MOS-Struktur existiert. Folgendessen ist die TJBS als Z-Diode für den Einsatz in Kfz-Generatorsystemen gut geeignet.

Eine Variante der in der DE-OS 10 2004 053 761 offenbarten TJBS wird in der EP 1 139 433 offenbart. Die Gräben der darin in der Figur 6 gezeigten Diode sind in zwei Bereiche aufgeteilt, wobei der obere Bereich mit stärker dotiertem p-Poly-Silizium als der untere Bereich ausgefüllt ist. Eine ähnliche Diode offenbart auch die DE 198 20 734.

### Offenbarung der Erfindung

Aufgabe der Erfindung ist, Schottky-Dioden mit hoher Robustheit und flexiblen Auslegungsmöglichkeiten zur Erfüllung unterschiedlicher Anforderungen an Durchbruchspannung, Leckstrom und Flussspannung, bereitzustellen, die geeignet sind als Z-Leistungsdioden für Einsatz in Kfz-Generatorsystemen.

### Vorteile der Erfindung

Das angegebene Ausführungsbeispiel einer Schottky-Diode hat den Vorteil dass die Kombination der Dotierkonzentrationen in der p-Wanne je nach Anforderungen flexibel definiert werden kann. Im Vergleich zu den bekannten TJBS wird somit eine Flexibilität bei Bauelementeauslegung erreicht. Diese Vorteile werden erreicht durch eine Halbleiteranordnung gemäß Anspruch 1.

### Zeichnung

Die Zeichnung zeigt in den einzelnen Figuren:
- Fig. 1:: JBS (Junction-Barrier-Schottky-Diode)
- Fig. 2:: TJBS (Trench-Junction-Barrier-Schottky-Diode) mit ausgefüllten Graben
- Fig. 3:: TJBS-Variante
- Fig. 4:: TJBS-Variante
- Fig. 5:: TJBS-Variante
- Fig. 6:: TJBS-Variante dieser Erfindung: Ausführungsbeispiel

### Ausführungsformen der Erfindung

Im Allgemeinen ist die Abschirmwirkung des Barrier-Lowering-Effekts bei TJBS mit einer stark dotierten p⁺-Wanne bei gleicher Abmessung der Gräben (*Wm, Wt, Dt,* siehe Fig. 2) besser, da die Raumladungszonen sich vorwiegend in der schwach dotierten n-Epischicht ausdehnen und ein abrupter PN-Übergang vorliegt. Dies führt bei gleicher Dotierkonzentration der n-Epischicht zu einem niedrigeren Leckstrom durch die bessere Abschirmwirkung des Barrier-Lowering-Effekts. Dem steht aber eine höhere Flussspannung als Nachteil gegenüber. Falls die Dotierkonzentration der n-Epischicht nach der Anforderung an Durchbruchspannung ausgelegt werden soll, dann muss die n-Epischicht bei einem abrupten PN-Übergang schwach dotiert werden. Dies hat einen niedrigeren Leckstrom als Vorteil und eine höhere Flussspannung als Nachteil zur Folge.

Anderseits ist bei einer schwach dotierten p-Wanne mit einer schwächeren Abschirmwirkung des Barrier-Lowering-Effekts zu erwarten, da die Raumladungszonen sich sowohl in der schwach dotierten n-Epischicht als auch in der schwach dotierten p-Wanne ausdehnen, wodurch ein graduierter PN-Übergang vorliegt. Hinzu kommt die Tatsache, dass bei gleicher Anforderung an Durchbruchspannung die n-Epischicht, verglichen mit einem abrupten PN-Übergang, stärker dotiert werden muss. Der Vorteil davon ist eine niedrigere Flussspannung. Der Nachteil ist höherer Leckstrom.

Beim bisherigen Konzept für TJBS nach der DE-OS 10 2004 053 761 ist eine einheitliche Dotierkonzentration in der p-Wanne vorgesehen und der Spielraum bei der Baulementeauslegung ist daher begrenzt. Wenn man aber die p-Wanne von oben nach unten in unterschiedlichen Bereichen aufteilt und flexible Kombinationen der Dotierkonzentrationen einsetzt, d. h. eine einheitliche Dotierkonzentration in der p-Wanne aufgibt, kann zusätzliche Auslegungsfreiheit gewonnen werden und das Bauelement je nach Anforderungen an Durchbruchspannung, Leckstrom und Flussspannung flexibel ausgelegt werden.

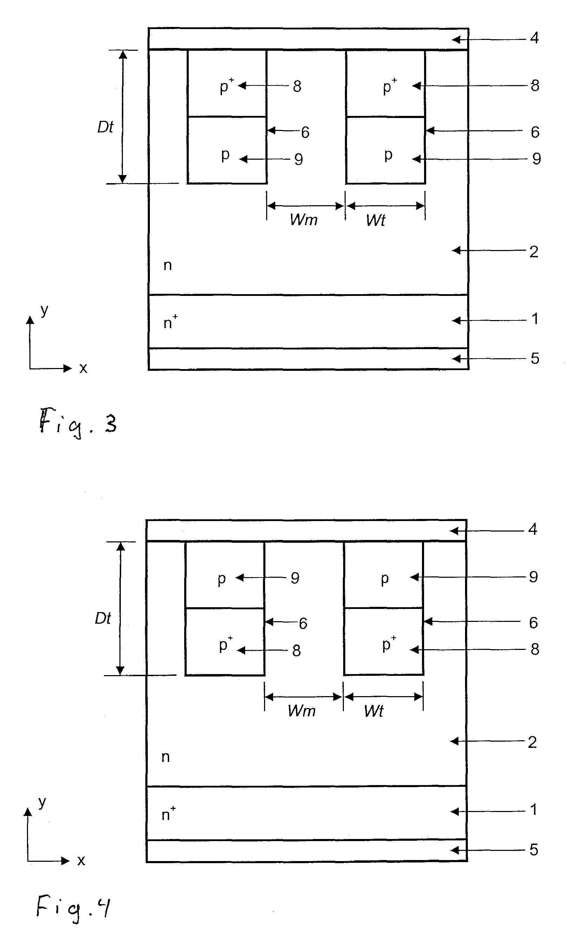

Ein erstes Beispiel, das keine Ausführungsform der Erfindung darstellt, ist in Fig. 3 dargestellt. Diese TJBS-Variante besteht aus einem n⁺-Substrat 1, einer n-Epischicht 2, mindestens zwei in die n-Epischicht 2 eingeätzten Gräben bzw. Trenches 6 mit einer Breite *Wt,* einer Tiefe *Dt* und einem Abstand zwischen den benachbarten Gräben 6 *Wm,* und Metallschichten an der Vorderseite des Chips 4 als Anodenelektrode und an der Rückseite des Chips 5 als Kathodenelektrode. Der obere Bereich der Gräben 6 wird mit stark dotiertem p⁺-Si oder p⁺-Poly-Si 8 und der untere Bereich mit schwach dotiertem p-Si oder p-Poly-Si 9 ausgefüllt.

Diese TJBS-Variante ist wieder eine Kombination von einer Schottky-Diode mit einer Schottky-Barriere zwischen der Metallschicht **4** als Anode und der n-Epischicht **2** als Kathode und einer PN-Diode mit einem PN-Übergang zwischen der p-Wanne als Anode und der n-Epischicht **2** als Kathode. Im Unterschied zu der in Fig. 2 dargestellten TJBS ist die p-Wanne jetzt von oben nach unten in zwei Bereichen aufgeteilt. Der obere Bereich der Gräben **6** mit stark dotiertem p⁺-Si oder p⁺-Poly-Si **8** stellt zusammen mit der n-Epischicht **2** einen abrupten PN-Übergang dar, der untere Bereich mit schwach dotiertem p-Si oder p-Poly-Si **9** zusammen mit der n-Epischicht **2** einen graduierten PN-Übergang. Mit dem graduierten PN-Übergang in dem unteren Bereich der Gräben kann höhere Durchbruchspannung und/oder niedrigere Flussspannung realisiert werden, während der abrupte PN-Übergang in dem oberen Bereich der Gräben für eine ausreichende Abschirmwirkung des Barrier-Lowering-Effekts und dadurch für einen kleinen Leckstrom sorgt.

Ein zweites Beispiel, das keine Ausführungsform der Erfindung darstellt, ist in der Fig. 4 gezeigt. Der Unterschied zu der in Abb. 3 dargestellten TJBS-Variante ist, dass nun der obere Bereich der Gräben **6** mit schwach dotiertem p-Si oder p-Poly-Si **9** und der untere Bereich mit stark dotiertem p⁺-Si oder p⁺-Poly-Si **8** ausgefüllt ist. Der obere Bereich mit schwach dotiertem p-Si oder p-Poly-Si **9** zusammen mit der n-Epischicht **2** stellt einen graduierten PN-Übergang dar und der untere Bereich der Gräben **6** mit stark dotiertem p⁺-Si oder p⁺-Poly-Si **8** zusammen mit der n-Epischicht **2** einen abrupten PN-Übergang. Mit dem abrupten PN-Übergang in dem unteren Bereich der Gräben kann gute Abschirmwirkung des Barrier-Lowering-Effekts erzielt und dadurch ein kleiner Leckstrom realisiert werden. Mit dem graduierten PN-Übergang im oberen Bereich der Gräben wird die Flussspannung weniger stark erhöht, als dies bei vollständig ausgeführtem abruptem PN-Übergang der Fall wäre. Diese Variante ist vorteilhaft für TJBS mit niedrigerer Durchbruchspannung.

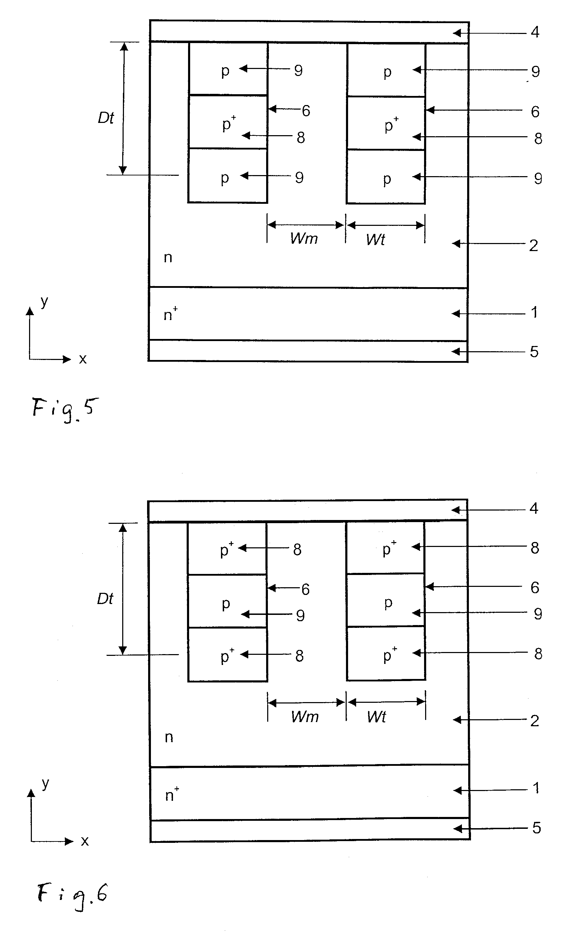

Weitere TJBS-Varianten sind in Fig. 5 und Fig. 6 dargestellt. Bei dem Beispiel in Fig. 5 , das keine Ausführungsform der Erfindung darstellt, wird die p-Wanne von oben nach unten in drei
Bereichen aufgeteilt: der mittlere Bereich wird mit stark dotiertem p⁺-Si oder p⁺-Poly-Si **8** ausgefüllt und der obere und untere Bereich mit schwach dotiertem p-Si oder p-Poly-Si **9.**

Bei dem Ausführungsbeispiel der Erfindung in Fig. 6 wird die p-Wanne ebenfalls von oben nach unten
in drei Bereichen aufgeteilt: der mittlere Bereich wird mit schwach dotiertem p-Si oder p-Poly-Si 9 ausgefüllt und der obere und untere Bereich mit stark dotiertem p⁺-Si oder p⁺-Poly-Si **8**.Im Vergleich zu den in Abb. 3 und 4 dargestellten TJBS-Varianten bieten die in Fig. 5 und 6 gezeigten Varianten noch mehr Freiräume bei Bauelementeauslegung mit geringfügigem Mehraufwand bei Prozessführung.Bei der TJBS-Variante dieser
Erfindung fließen Ströme in der Flussrichtung, wie bei konventioneller JBS oder TJBS, nur durch die Schottky-Diode, falls die Flussspannung der TJBS-Variante dieser Erfindung
deutlich kleiner als die Flussspannung der PN-Diode ist.

Die TJBS-Variante dieser Erfindung bietet hohe Robustheit durch die Klammerfunktion
wie eine in Abb. 2 dargestellte TJBS. Die Durchbruchspannung der PN-Diode *BV_pn* wird so ausgelegt, dass *BV_pn* niedriger als die Durchbruchspannung der Schottky-Diode *BV*_*schottky* ist und der Durchbruch am PN-Übergang zwischen dem unteren Bereich der p-Wannen und dem n-Epischicht **2** stattfindet. Im Durchbruchsbetrieb fließen Sperrströme dann nur durch den PN-Übergang. Die TJBS-Variante dieser Erfindung verfügt damit über ähnliche Robustheit wie eine PN-Diode. Im Vergleich zur TJBS mit einheitlicher Dotierkonzentration in der p-Wanne bietet die TJBS-Variante dieser Erfindung vorteilhaft
größere Freiräume für die Bauelementeauslegung Dadurch können Anforderungen wie an Durchbruchspannung, Leckstrom und Flussspannung besser und flexibeler erfüllt werden.

Die TJBS-Variante dieser Erfindung wird durch das Verfahren gemäß Anspruch 10 hergestellt.

Bei der TJBS-Variante dieser Erfindung können im Randbereich des Chips noch zusätzliche Strukturen zur Reduktion der Randfeldstärke aufweisen. Dies können z. B. niedrig dotierte p-Bereiche, Feldplatten oder ähnliche dem Stand der Technik entsprechende Strukturen sein.

## Patentansprüche

1. Halbleiteranordnung mit einer Trench-Junction-Barrier-Schottky-Diode (TJBS) mit integrierter PN-Diode als Klammerelement, wobei die Trench-Junction-Barrier-Schottky-Diode (TJBS) aus einer Kombination von Schottky-Diode und PN-Diode besteht, wobei die Durchbruchspannung der PN-Diode *(BV_pn)* niedriger als die Durchbruchspannung der Schottky-Diode (*BV_schottky*) ist, wobei die Halbleiteranordnung eine n-Epischicht (2) auf einem n⁺-Substrat (1) aufweist, die als Kathodenzone dient, , und wobei in der zweidimensionalen Darstellung mindestens zwei in die n-Epischicht (2) eingeätzten Gräben (6) vorhanden sind und die Gräben (6) mit p-dotiertem Si oder Poly-Si ausgefüllt sind und die Anodenzone der PN-Diode bilden, **dadurch gekennzeichnet, dass** die Gräben (6) von oben nach unten in drei Bereiche aufgeteilt sind und mit p-dotiertem Si oder Poly-Si unterschiedlicher Dotierkonzentrationen ausgefüllt sind, wobei der obere Bereich mit stark dotiertem p-Silizium oder p-Poly-Silizium (6), der mittlere Bereich mit schwach dotiertem p-Silizium oder p-Poly-Silizium (6) und der untere Bereich mit stark dotiertem p⁺-Silizium oder p⁺-Poly-Silizium ausgefüllt sind.

2. Halbleiteranordnung nach Anspruch 1, **dadurch gekennzeichnet, dass** ihre Durchbruchspannung *(BV_pn)* bei 20V liegt und sie so ausgestaltet ist, dass sie als Z-Diode wirkt und mit hohen Strömen im Durchbruch betreibbar ist.

3. Halbleiteranordnung nach einem der vorhergehenden Ansprüche, **dadurch gekennzeichnet, dass** die starken und schwachen Dotierkonzentrationen innerhalb des jeweiligen stark oder schwach dotierten Bereichs einen Dotiergradienten aufweisen.

4. Halbleiteranordnung nach einem der vorhergehenden Ansprüche, **dadurch gekennzeichnet, dass** sich eine Metallschicht (5) an der Rückseite des Chips befindet und als Kathodenelektrode dient, und eine Metallschicht (4) an der Vorderseite des Chips angeordnet ist, mit ohmschem Kontakt zum stark p-dotierten oberen Bereich der Gräben und mit Schottky-Kontakt zur n-Epischicht (2) und als Anodenelektrode dient.

5. Halbleiteranordnung nach einem der vorhergehenden Ansprüche, **dadurch gekennzeichnet, dass** die Gräben (6) über eine rechteckige Form oder eine U-Form verfügen.

6. Halbleiteranordnung nach einem der vorhergehenden Ansprüche, **dadurch gekennzeichnet, dass** der Durchbruch der PN-Diode am Übergang zwischen dem unteren Bereich der Gräben und der n-Epischicht (2) stattfindet.

7. Halbleiteranordnung nach einem der vorhergehenden Ansprüche, **dadurch gekennzeichnet, dass** die Metallisierung der Metallschicht (4) und/oder (5) aus zwei oder mehreren übereinander liegenden Metalllagen besteht.

8. Halbleiteranordnung nach einem der vorhergehenden Ansprüche, **dadurch gekennzeichnet, dass** die Gräben (6) in Streifenanordnung oder als Inseln angeordnet sind, wobei die Inseln kreisförmig oder sechseckig ausgestaltet sind.

9. Halbleiteranordnung nach einem der vorhergehenden Ansprüche, **dadurch gekennzeichnet, dass** sie Bestandteil eines Gleichrichters für ein Kfz-Generatorsystem ist.

10. Verfahren zu Herstellung einer Halbleiteranordnung nach einem der vorhergehenden Ansprüche, **dadurch gekennzeichnet, dass** wenigstens die Schritte:
- Bereitstellung eines n⁺ -Substrates als Ausgangsmaterial
- n-Epitaxie
- Grabenätzen
- Ausfüllen der Gräben mit stark p⁺-dotiertem und schwach p-dotiertem Si oder Poly-Si nach Auslegung der Dotierungskombination in den Gräben wie im Anspruch 1,
- Metallisierung auf Vorder- und Rückseite
durchgeführt werden.

## Claims

1. Semiconductor arrangement comprising a trench junction barrier Schottky diode (TJBS) comprising an integrated PN diode as a clamping element, wherein the trench junction barrier Schottky diode (TJBS) consists of a combination of Schottky diode and PN diode, wherein the breakdown voltage of the PN diode (*BV_pn*) is lower than the breakdown voltage of the Schottky diode (*BV*_*schottky*), wherein the semiconductor arrangement comprises an n-type epitaxial layer (2) on an n⁺-type substrate (1), said epitaxial layer serving as a cathode zone, and wherein in the two-dimensional representation at least two trenches (6) etched into the n-type epitaxial layer (2) are present and the trenches (6) are filled with p-doped Si or poly-Si and form the anode zone of the PN diode, **characterized in that** the trenches (6) are divided into three regions from top to bottom and are filled with p-doped Si or poly-Si having different doping concentrations, wherein the upper region is filled with heavily doped p-type silicon or p-type polysilicon (6), the central region is filled with weakly doped p-type silicon or p-type polysilicon (6) and the lower region is filled with heavily doped p⁺-type silicon or p⁺-type polysilicon.

2. Semiconductor arrangement according to Claim 1, **characterized in that** its breakdown voltage *(BV_pn)* is 20V and it is configured such that it acts as a Zener diode and is operable with high currents at breakdown.

3. Semiconductor arrangement according to either of the preceding claims, **characterized in that** the heavy and weak doping concentrations within the respective heavily or weakly doped region have a doping gradient.

4. Semiconductor arrangement according to any of the preceding claims, **characterized in that** a metal layer (5) is situated at the rear side of the chip and serves as a cathode electrode, and a metal layer (4) is arranged at the front side of the chip, with ohmage contact with the heavily p-doped upper region of the trenches and with Schottky contact with the n-type epitaxial layer (2) and serves as an anode electrode.

5. Semiconductor arrangement according to any of the preceding claims, **characterized in that** the trenches (6) have a rectangular shape or a U-shape.

6. Semiconductor arrangement according to any of the preceding claims, **characterized in that** the breakdown of the PN diode takes place at the junction between the lower region of the trenches and the n-type epitaxial layer (2).

7. Semiconductor arrangement according to any of the preceding claims, **characterized in that** the metallization of the metal layer (4) and/or (5) consists of two or more metal plies lying one above another.

8. Semiconductor arrangement according to any of the preceding claims, **characterized in that** the trenches (6) are arranged in strip arrangement or as islands, wherein the islands are configured in circular or hexagonal fashion.

9. Semiconductor arrangement according to any of the preceding claims, **characterized in that** it is part of a rectifier for a motor vehicle generator system.

10. Method for producing a semiconductor arrangement according to any of the preceding claims, **characterized in that** at least the steps:
- providing an n⁺-type substrate as starting material
- n-type epitaxy
- trench etching
- filling the trenches with heavily p⁺-doped and weakly p-doped Si or poly-Si after designing the doping combination in the trenches as in Claim 1,
- metallization of front and rear sides are carried out.

## Revendications

1. Ensemble semi-conducteur comportant une diode barrière Schottky à jonction de tranchée (TJBS) à diode PN intégrée en tant qu'élément de blocage, dans lequel la diode barrière Schottky à jonction de tranchée (TJBS) est constituée d'une combinaison d'une diode Schottky et d'une diode PN, dans lequel la tension de claquage de la diode PN *(BV_pn)* est inférieure à la tension de claquage de la diode Schottky (*BV*_*schottky*), dans lequel l'ensemble semi-conducteur comporte une couche épitaxiale n (2) sur un substrat n⁺ (1), qui est utilisée en tant que zone de cathode, et dans lequel au moins deux tranchées (6) gravées dans la couche épitaxiale n (2) en représentation bidimensionnelle sont présentes et les tranchées (6) sont remplies de Si ou de polySi dopé p et forment la zone d'anode de la diode PN, **caractérisé en ce que** les tranchées (6) sont divisées de haut en bas en trois régions et sont remplies de Si ou de polySi dopé p ayant des concentrations de dopant différentes, dans lequel la région supérieure est remplie de silicium p ou de polysilicium p (6) fortement dopé, la région intermédiaire est remplie de silicium faiblement dopé p ou de polysilicium faiblement dopé p (6) et la région inférieure est remplie de silicium fortement dopé p⁺ ou de polysilicium fortement dopé p⁺.

2. Ensemble semi-conducteur selon la revendication 1, **caractérisé en ce que** sa tension de claquage (*BV_pn*) se situe à 20 V et **en ce qu'**il est configuré pour fonctionner en tant que diode Z et peut être mis en fonctionnement avec de forts courants de claquage.

3. Ensemble semi-conducteur selon l'une quelconque des revendications précédentes, **caractérisé en ce que** les fortes et faibles concentrations de dopant présentent un gradient de dopant à l'intérieur de la région respective fortement ou faiblement dopée.

4. Ensemble semi-conducteur selon l'une quelconque des revendications précédentes, **caractérisé en ce que** une couche métallique (5) est présente sur la face arrière de la puce et joue le rôle d'électrode de cathode, et **en ce qu'**une couche métallique (4) est disposée sur la face avant de la puce, en contact ohmique avec la région supérieure fortement dopée p et en contact Schottky avec la couche épitaxiale n (2), et joue le rôle d'électrode d'anode.

5. Ensemble semi-conducteur selon l'une quelconque des revendications précédentes, **caractérisé en ce que** les tranchées (6) présentent une forme rectangulaire ou une forme en U.

6. Ensemble semi-conducteur selon l'une quelconque des revendications précédentes, **caractérisé en ce que** le claquage de la diode PN se produit à la transition entre la région inférieure des tranchées et la couche épitaxiale n (2).

7. Ensemble semi-conducteur selon l'une quelconque des revendications précédentes, **caractérisé en ce que** la métallisation de la couche métallique (4) et/ou (5) est constitué de deux alliages métalliques ou plus superposés l'un à l'autre.

8. Ensemble semi-conducteur selon l'une quelconque des revendications précédentes, **caractérisé en ce que** les tranchées (6) sont disposées sous forme de bandes ou d'îlots, dans lequel les îlots sont configurés sous forme circulaire ou hexagonale.

9. Ensemble semi-conducteur selon l'une quelconque des revendications précédentes, **caractérisé en ce qu'**il fait partie d'un redresseur destiné à un système de générateur d'automobile.

10. Procédé de fabrication d'un ensemble semi-conducteur selon l'une quelconque des revendications précédentes, **caractérisé en ce qu'**il consiste à :
- fournir un substrat n⁺ en tant que matériau de départ,
- effectuer une épitaxie n,
- graver des tranchées,
- remplir les tranchées de Si ou de polySi fortement dopé p⁺ ou faiblement dopé p selon la configuration de la combinaison de dopant dans les tranchées comme indiqué à la revendication 1,
- métalliser les faces avant et arrière.
